# EUROPÄISCHE PATENTSCHRIFT

(11) **EP 1 329 903 B1**
(45) Veröffentlichungstag und Bekanntmachung des Hinweises auf die Patenterteilung: **20.04.2005**
(21) Anmeldenummer: 02000941.1
(22) Anmeldetag: 16.01.2002
(51) Int. Cl.: G11C 29/00

(54) **Speichereinrichtung, die durch eine einen oder mehrere Schreibzugriffe umfassende Kommandosequenz in eine Testbetriebsart versetzbar ist**
Memory device switched into test mode by a command sequence comprising a single or a plurality of read instructions
Dispositif de mémoire commuté dans le mode test par une séquence de commande ayant une ou plusieurs instructions de lecture

(43) Veröffentlichungstag der Anmeldung: 23.07.2003
(73) Patentinhaber: Infineon Technologies AG, 81669 München (DE)
(72) Erfinder: Vowe, Achim, Dr., 80469 München (DE)
(74) Vertreter: Repkow, Ines, Dr. Dipl.-Ing.

(56) Entgegenhaltungen:
- EP-A- 0 752 706
- US-A- 5 526 311
- US-A- 5 781 485

## Beschreibung

Die vorliegende Erfindung betrifft eine Vorrichtung gemäß dem Oberbegriff des Patentanspruchs 1, d.h. eine Speichereinrichtung zum Speichern von Daten, wobei die Speichereinrichtung zum Testen derselben in eine bestimmte Tests der Speichereinrichtung ermöglichende Testbetriebsart versetzbar ist.

Eine solche Speichereinrichtung ist beispielsweise ein Flash-Speicher. Flash-Speicher sind seit vielen Jahren in unzähligen Ausführungsformen bekannt und bedürfen keiner näheren Erläuterung.

Flash-Speicher können entweder als separate Bausteine realisiert sein, oder in anderen Bausteinen wie beispielsweise einem Mikrocontroller enthalten sein.

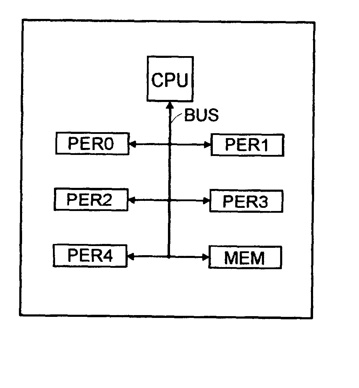

Ein Mikrocontroller mit einem internen Flash-Speicher ist in der Figur gezeigt.

Der gezeigte Mikrocontroller enthält eine CPU CPU, Peripherieeinheiten PER0 bis PER4, einen Flash-Speicher MEM, und einen die genannten Komponenten miteinander verbindenden Bus BUS; die Peripherieeinheiten PER0 bis PER4 können beispielsweise ein DMA-Controller, ein Timer, eine serielle Schnittstelle, eine parallele Schnittstelle, einen A/D-Wandler, einen D/A-Wandler, oder sonstige Komponenten umfassen.

Im normalen Betrieb des Mikrocontrollers kann jede Mikrocontroller-Komponente, die am Bus BUS Bus-Master werden kann, den Flash-Speicher MEM löschen, beschreiben, und auslesen. Wie dies im einzelnen geschieht, ist bekannt und bedarf keiner näheren Erläuterung.

Der Flash-Speicher MEM ist darüber hinaus in eine Testbetriebsart versetzbar, in welcher bestimmte, im normalen Betrieb des Flash-Speichers nicht oder nur mit großem Aufwand durchführbare Tests des Flash-Speichers durchführbar sind.

Das Versetzen des Flash-Speichers MEM in die Testbetriebsart erfolgt bei den bekannten Bausteinen, die einen Flash-Speicher enthalten, dadurch, daß an einen oder mehrere Pins des betreffenden Bausteins bestimmte Signale oder Signalfolgen angelegt werden, wie z.B. aus der EP 0 752 706 bekannt.

Diese Art des Versetzens des Flash-Speichers MEM in die Testbetriebsart hat den Nachteil, daß es passieren kann, daß der Flash-Speicher unbeabsichtigt in die Testbetriebsart versetzt wird. Dies wiederum kann zur Folge haben, daß der Flash-Speicher die von ihm gerade auszuführende Operation nicht oder anders ausführt als es im Normalbetrieb der Fall ist, wodurch es zu Störungen oder Fehlfunktionen des den Flash-Speichers enthaltenden Systems kommen kann. Dies ist aber in Systemen, in welchen es auf höchste Sicherheit ankommt, beispielsweise in Systemen zur Steuerung des Anti-Blockiersystems oder des Airbags in einem Kraftfahrzeug nicht tolerierbar, und zwar auch dann nicht, wenn die Wahrscheinlichkeit von Störungen oder Fehlfunktionen sehr gering ist.

Entsprechendes gilt auch für andere Speichereinrichtungen wie RAMs, ROMs, EPROMs, EEPROMs etc.

Der vorliegenden Erfindung liegt daher die Aufgabe zugrunde, eine Möglichkeit zu finden, durch welche die Wahrscheinlichkeit, daß eine Speichereinrichtung unbeabsichtigt in die Testbetriebsart versetzt wird, auf ein Minimum reduzierbar ist.

Diese Aufgabe wird erfindungsgemäß durch die in Patentanspruch 1 beanspruchte Speichereinrichtung gelöst.

Die erfindungsgemäße Speichereinrichtung zeichnet sich dadurch aus, daß die Speichereinrichtung durch eine einen bestimmten Schreibzugriff oder eine bestimmte Folge von Schreibzugriffen auf die Speichereinrichtung umfassende Kommandosequenz in die Testbetriebsart versetzbar ist.

Dadurch kann insbesondere dann, wenn dafür gesorgt wird, daß nur innerhalb des die Speichereinrichtung enthaltenden Bausteins vorgesehene Einrichtungen Zugriff auf die Speichereinrichtung haben, und/oder die Speichereinrichtung durch geeignete Schutzmechanismen vor bestimmten oder allen Zugriffen auf sie geschützt ist, mit an Sicherheit grenzender Wahrscheinlichkeit ausgeschlossen werden, daß die Speichereinrichtung versehentlich oder mißbräuchlich in die Testbetriebsart versetzt wird.

Vorteilhafte Weiterbildungen der Erfindung sind den Unteransprüchen, der folgenden Beschreibung, und den Figuren entnehmbar.

Die Erfindung wird nachfolgend anhand eines Ausführungsbeispiels unter Bezugnahme auf die Figur näher erläutert.

Die Figur zeigt den Aufbau eines eine Speichereinrichtung enthaltenden Mikrocontrollers.

Die im folgenden beschriebene Speichereinrichtung ist ein Flash-Speicher. Es sei jedoch bereits an dieser Stelle darauf hingewiesen, daß es sich prinzipiell auch um einen beliebigen anderen Speicher handeln könnte, beispielsweise um ein RAM, ein ROM, ein EPROM, ein EEPROM, etc.

Der beschriebene Flash-Speicher ist im betrachteten Beispiel Bestandteil eines Mikrocontrollers oder einer sonstigen programmgesteuerten Einheit wie eines Mikroprozessors oder eines Signalprozessors. Er könnte jedoch auch Bestandteil eines beliebigen anderen Bausteins sein, wobei dieser Baustein auch ein nur den Flash-Speicher enthaltender (Speicher-)Baustein sein kann.

Der den Flash-Speicher enthaltende Mikrocontroller kann beispielsweise der in der Figur gezeigte und eingangs bereits unter Bezugnahme darauf beschriebene Mikrocontroller sein; im betrachteten Beispiel wird davon ausgegangen, daß der in der Figur gezeigte Mikrocontroller der den vorliegend betrachteten Flash-Speicher enthaltende Mikrocontroller ist.

Wie bereits erwähnt wurde, kann bei der in der Figur gezeigten Anordnung jede Mikrocontroller-Komponente, die Bus-Master am Bus BUS werden kann, den Flash-Speicher auslesen, beschreiben und löschen. Bei den weiteren Ausführungen wird davon ausgegangen, daß die CPU CPU die Mikrocontroller-Komponente ist, die den Flash-Speicher ausliest, beschreibt, oder löscht. Die hierzu gegebenen Erläuterungen gelten für den Fall, daß eine andere Mikrocontroller-Komponente den Flash-Speicher ausliest, beschreibt, oder löscht, entsprechend.

Zumindest das Beschreiben und Löschen des Flash-Speichers erfolgen im betrachteten Beispiel unter Verwendung von Kommandosequenzen. Eine Kommandosequenz besteht aus einer Abfolge von Schreibzugriffen auf den Flash-Speicher, wobei die hierbei zu verwendenden Adressen und Daten durch die jeweilige Syntax der durch die Kommandosequenz zu veranlassende Operation vorgegeben sind.

Beispielsweise kann das Löschen eines Flash-Speicher-Sektors mit der Nummer SA durch die Kommandosequenz (hBB, h12) (h23, hBB) (SA, h50) veranlaßt werden, wobei (hBB, h12), (h23, hBB) und (SA, h50) drei aufeinanderfolgende Schreibzugriffe auf den Flash-Speicher darstellen, wobei in der gewählten Darstellungsform dieser Schreibzugriffe
- der jeweils erste Wert, d.h. der jeweils vor dem Komma stehende Wert, die zu verwendende Adresse repräsentiert,
- der jeweils zweite Wert, d.h. der jeweils nach dem Komma stehende Wert, die zu übertragenden Daten repräsentiert, und
- das vorangestellte "h" jeweils bedeutet, daß es sich um einen Hexadezimal-Wert handelt.

Die Programmierung und das Löschen von Flash-Speichern durch Kommandosequenzen ist in verschiedenen Standards beschrieben. Die einzelnen Kommandos und deren Syntax sind jedoch produktspezifisch.

Die Kommandosequenzen werden einem im Flash-Speicher enthaltenen Kommando-Interpreter zugeführt, und dieser entscheidet anhand der erhaltenen Daten und/oder der verwendeten Adresse (oder eines bestimmten Teils derselben), welche Operation durchzuführen ist.

Das Ansprechen des Flash-Speichers unter Verwendung von Kommandosequenzen erweist sich als vorteilhaft, weil dadurch den Besonderheiten von Flash-Speichern, insbesondere der Besonderheit, daß das Beschreiben und Löschen von Flash-Speichern nur blockweise (sektor- oder pageweise) erfolgen kann, besser Rechnung getragen werden kann.

Der vorliegend betrachtete Flash-Speicher kann durch eine solche Kommandosequenz auch in die Testbetriebsart versetzt werden. Die Kommandosequenz, durch welche der Flash-Speicher in die Testbetriebsart versetzt wird, wird im folgenden als Test-Mode-Entry-Kommandosequenz bezeichnet.

In der Testbetriebsart können bestimmte Operationen durchgeführt werden, die im normalen Betrieb des Flash-Speichers nicht durchgeführt werden können. Zu diesen Operationen gehören beispielsweise das Beschreiben und/oder das Auslesen von internen Registern des Flash-Speichers, oder das Schaffen bestimmter Bedingungen für bestimmte Operationen (auch für im normalen Betrieb des Flash-Speichers oder in sonstigen Betriebsarten ausführbare Operationen). Hierdurch kann beispielsweise, aber bei weitem nicht ausschließlich die ordnungsgemäße Funktion einer Fehlererkennungseinheit und/oder einer Fehlerkorrektureinheit des Flash-Speichers getestet werden, durch welche in den aus dem Flash-Speicher ausgelesenen Daten vorhandene Fehler erkannt und/oder korrigiert werden.

Die Test-Mode-Entry-Kommandosequenz wird ausgeführt wie eine "normale" Kommandosequenz. D.h., sie besteht aus einer Sequenz mehrerer aufeinanderfolgender Schreibzugriffe auf den Flash-Speicher, wobei diese Schreibzugriffe auch wieder von dem bereits erwähnten Kommando-Interpreter ausgewertet werden.

Die Test-Mode-Entry-Kommandosequenz kann beispielsweise die Schreibzugriffsfolge (hAA, h11) (hBB, h12) (hCC, h13) (hDD, h14) umfassen.

Wie später noch genauer beschrieben wird, hat die Zuführung der Test-Mode-Entry-Kommandosequenz zum Flash-Speicher zur Folge, daß der Flash-Speicher in einen Zustand versetzt wird, in welchem durch sich daran anschließende Schreibzugriffe auf den Flash-Speicher Operationen veranlaßt werden können, die im normalen Betrieb des Flash-Speichers, d.h. außerhalb der Testbetriebsart desselben nicht ausgeführt werden können. Es sei jedoch bereits an dieser Stelle darauf hingewiesen, daß zusätzlich oder alternativ auch vorgesehen werden könnte, die Ausführung dieser Operationen schon durch die Test-Mode-Entry-Kommandosequenz zu veranlassen.

Die Test-Mode-Entry-Kommandosequenz und vorzugsweise auch die anderen Kommandos oder Kommandosequenzen, durch welche der Flash-Speicher zur Durchführung von Operationen veranlaßbar ist, die außerhalb der Testbetriebsart desselben nicht ausgeführt werden können, sind vorzugsweise geheim, d.h. dem Benutzer des Flash-Speichers nicht bekannt. Vorzugsweise ist es darüber hinaus so, daß der Flash-Speicher die Test-Mode-Entry-Kommandosequenz und/oder die sonstigen geheimen Kommandos oder Kommandosequenzen nach außen hin als unzulässig behandelt, also beispielsweise mit der Ausgabe eines Fehlersignals quittiert. Vorzugsweise wird sogar jeder einzelne Schreibzugriff der geheimen Kommandos oder Kommandosequenzen so behandelt. D.h., daß nach jedem Schreibzugriff auf den Flash-Speicher, der nicht zu einer in der normalen Betriebsart des Flash-Speichers zulässigen Schreibzugriffsfolge gehören kann, ein Fehlersignal ausgegeben wird. Vorzugsweise ist es ferner so, daß dann, wenn nach begonnener Eingabe der Test-Mode-Entry-Kommandosequenz oder in der Testbetriebsart des Flash-Speichers ein Schreibzugriff auf den Flash-Speicher erfolgt, welcher zu einem Kommando oder einer Kommandosequenz gehört oder gehören kann, das bzw. die im normalen Betrieb des Flash-Speichers ausführbar ist, dieser Schreibzugriff ein automatisches und von außen nicht erkennbares Zurücksetzen des Flash-Speichers in die normale Betriebsart bewirkt, und sowohl nach außen hin als auch intern als zulässiger Schreibzugriff behandelt wird und die zugeordneten Operationen im Flash-Speicher auslöst. Dadurch ist es nicht oder jedenfalls nicht ohne weiteres möglich, die Test-Mode-Entry-Kommandosequenz und die in der Testbetriebsart zulässigen Zugriffe auf den Flash-Speicher durch Versuche herauszufinden. Dies ist sehr bedeutsam, weil Hacker dadurch nur vernachlässigbar geringe Chancen haben, nähere Einzelheiten über den Aufbau und die Funktion des Flash-Speichers auszukundschaften, und es demzufolge schwieriger, wenn nicht gar unmöglich ist, Betriebsgeheimnisse des Herstellers des Flash-Speichers oder des den Flash-Speicher enthaltenden Systems auszuspionieren, und/oder Sicherheitslücken in implementierten Schutzmechanismen aufzudecken, und/oder sonstige Informationen in Erfahrung zu bringen, die zum Nachteil Herstellers des Flash-Speichers oder des den Flash-Speicher enthaltenden Systems verwendet werden können.

Vorzugsweise läßt sich der Flash-Speicher dann, wenn er sich in einem sogenannten Protected Mode befindet, nicht in die Testbetriebsart versetzen. Im Protected Mode sind Schreibzugriffe und/oder Lesezugriffe, oder zumindest von bestimmten Mikrocontroller-Komponenten stammende Schreibzugriffe und/oder Lesezugriffe auf den Flash-Speicher oder bestimmte Teile desselben gesperrt. Der Flash-Speicher wird beispielsweise in den Protected Mode gebracht, wenn verhindert werden soll, daß der Speicherinhalt des Flash-Speichers durch dazu nicht berechtigte Personen verändert oder ausgelesen werden kann. Dadurch, daß der Flash-Speicher dann, wenn er sich im Protected Mode befindet, nicht in die Testbetriebsart versetzt werden kann, wird verhindert, daß der durch den Protected Mode gebotene Schutz des Flash-Speichers umgangen oder aufgehoben werden kann. Im betrachteten Beispiel ist es so, daß der Protected Mode durch Zuführung einer Passwort-Sequenz temporär aufgehoben werden kann, und daß der Flash-Speicher dann, wenn dies geschehen ist, wie beschrieben in die Testbetriebsart gebracht werden kann.

Die Zuführung der Test-Mode-Entry-Kommandosequenz zum Flash-Speicher hat im betrachteten Beispiel zur Folge, daß innerhalb des Flash-Speichers eine ein oder mehrere Bits umfassende Kennung gesetzt wird. Im betrachteten Beispiel besteht diese Kennung aus einem bestimmten Bit eines bestimmten Registers des Flash-Speichers. Dieses Bit wird im folgenden als Test-Enable-Bit bzw. TE-Bit bezeichnet. Das gesetzte TE-Bit ist die Voraussetzung dafür, daß im normalen Betrieb nicht zugängliche Register oder sonstige Speicher des Flash-Speichers ausgelesen und/oder beschrieben werden können, und/oder daß im Flash-Speicher implementierte Testfunktionen aktiviert werden können. Solange das TE-Bit gesetzt ist, können die genannten Operationen ausgeführt werden; wenn und so lange das TE-Bit zurückgesetzt ist, ist dies nicht möglich.

Vorzugsweise ist das TE-Bit nach dem Reset des den Flash-Speicher enthaltenden Bausteins automatisch immer zurückgesetzt, und kann das TE-Bit ausschließlich gesetzt werden, indem dem Flash-Speicher die Test-Mode-Entry-Kommandosequenz zugeführt wird.

Ein Zurücksetzen des TE-Bits ist gleichbedeutend mit dem Verlassen der Testbetriebsart. Das Zurücksetzen des TE-Bits kann auf Veranlassung des Benutzers und/oder automatisch erfolgen.

Das Zurücksetzen des TE-Bits auf Veranlassung des Benutzers kann durch einen entsprechenden Schreibzugriff auf den Flash-Speicher erfolgen, durch welchen das TE-Bit zurückgesetzt wird.

Für das automatische Zurücksetzen des TE-Bits existieren mehrere Möglichkeiten, von welchen nachfolgend stellvertretend drei beschrieben werden.

Die erste Möglichkeit besteht darin, daß das TE-Bit automatisch zurückgesetzt wird, wenn ein normaler, d.h. ein außerhalb der Testbetriebsart durchführbarer Zugriff auf den Flash-Speicher erfolgt.

Die zweite Möglichkeit besteht darin, daß das TE-Bit automatisch zurückgesetzt wird, wenn bei gesetztem TE-Bit ein ungültiger Zugriff auf den Flash-Speicher erfolgt.

Die dritte Möglichkeit besteht darin, daß das TE-Bit automatisch zurückgesetzt wird, wenn nach dem Setzen des TE-Bits eine vorbestimmte Zeit vergangen ist.

Es dürfte einleuchten und bedarf keiner näheren Erläuterung, daß in einem Flash-Speicher nicht alle der genannten Möglichkeiten zum Zurücksetzen des TE-Bits vorgesehen werden müssen. Es reicht auch aus, wenn nur eine oder zwei der genannten Möglichkeiten vorgesehen sind, wobei es prinzipiell keine Rolle spielt, welche Möglichkeit dies ist bzw. welche Möglichkeiten dies sind. Aus Sicherheitsgründen ist jedoch einer automatischen Rücksetzung der Vorrang zu geben.

Es kann sich als vorteilhaft erweisen, wenn das TE-Bit nach einem Zurücksetzen desselben erst nach einem Rücksetzen des Flash-Speichers oder des diesen enthaltenden Bausteins erneut gesetzt werden kann.

Es kann sich ferner als vorteilhaft erweisen, wenn der Flash-Speicher durch verschiedene Test-Mode-Entry-Kommandosequenzen in die Testbetriebsart versetzbar ist, wobei es von der jeweils verwendeten Test-Mode-Entry-Kommandosequenz abhängt, welche Operationen in der Testbetriebsart ausgeführt werden dürfen. Dadurch ist es möglich, ausgewählten oder allen Benutzern zu gestatten, den Flash-Speicher in eine beschränkte Testmöglichkeiten offerierende Testbetriebsart zu versetzen.

Es könnte auch vorgesehen werden, in die Test-Mode-Entry-Kommandosequenz ein Passwort zu integrieren (analog zu den vorstehend bereits Anwenderbefehlen, durch welche die temporäre Aufhebung des Protection Mode erfolgt). Dies würde unter anderem beispielsweise die Möglichkeit eröffnen, in die Testbetriebsart zu gelangen, ohne vorher mit den genannten Befehlen den Protection Mode zu verlassen zu müssen.

Aus Sicherheitsgründen sollten das in der Test-Mode-Entry-Kommandosequenz übermittelte Passwort und das zur temporären Aufhebung des Protection Mode verwendete Passwort jedoch bestimmte Gemeinsamkeiten oder gegenseitige Abhängigkeiten aufweisen, beispielsweise zumindest teilweise übereinstimmen, oder nach einem bestimmten Schema auseinander ableitbar sein. Dadurch kann ausgeschlossen werden, daß hierzu nicht autorisierte Personen den Protection Mode umgehen können.

Vorzugsweise ist zur Ermittlung eines gültigen Test-Mode-Entry-Passwortes nur die Kenntnis eines Teils des Test-Mode-Entry-Passwortes oder einer daraus abgeleiteten Größe wie beispielsweise einer daraus abgeleiteten Signatur erforderlich. Dadurch wäre es möglich, daß ein Kunde, der einen Flash-Speicher mit installierter Read und/oder Write Protection zum Hersteller zur Analyse zurückschickt, dem Hersteller nicht sein vollständiges Passwort preisgeben müßte.

Die Art und Weise, auf welche der vorstehend beschriebene Flash-Speicher in die Testbetriebsart versetzt wird, bietet einige wesentliche Vorteile.

Einer der Vorteile besteht darin, daß der Test des Flash-Speichers vollständig innerhalb des Flash-Speichers abgewickelt werden kann. Es sind keine zusätzlichen externen Ressourcen notwendig. Dadurch wird der Aufwand für die Systemintegration verringert und insbesondere die Integration in verschiedene Systemumgebungen erleichtert.

Ein weiterer Vorteil besteht darin, daß sich die Test-Mode-Entry-Kommandosequenz nahtlos in die bei Flash-Speichern schon vorhandene Struktur der Kommandosequenzen einfügt, und auch die in der Testbetriebsart durchgeführten Schreib/Lese-Zugriffe auf den Flash-Speicher über die ohnehin vorhandenen Ressourcen erfolgen.

Ein weiterer Vorteil besteht darin, daß, da der Testbetrieb vollständig innerhalb des Flash-Moduls abgewickelt wird, sich praktisch jede beliebige Kopplung mit der Flash Protection realisieren läßt. Insbesondere kann äußerst wirkungsvoll verhindert werden, daß ein im Protection Mode betriebener Flash-Speicher versehentlich oder durch eine dazu nicht befugte Person in die Testbetriebsart versetzt werden kann, bzw. die Testbetriebsart eine Möglichkeit darstellt, um dem Protection Mode zu deaktivieren oder zu umgehen.

Ein weiterer Vorteil besteht darin, daß die Test-Mode-Entry-Kommandosequenz aufgrund der Fehlersignale, die der Flash-Speicher nach jedem Schreibzugriff auf ihn ausgibt, der nicht zu einer der im normalen Betrieb des Flash-Speichers zulässigen Schreibzugriffsfolgen gehören kann, nicht einmal teilweise (durch sukzessive Teilentdeckung) ermittelt werden kann.

Ferner ist es bei dem vorstehend beschriebenen Flash-Speicher mit an Sicherheit grenzender Wahrscheinlichkeit ausgeschlossen, daß der Flash-Speicher versehentlich in die Testbetriebsart versetzt wird.

### Bezugszeichenliste

- BUS: Bus
- CPU: CPU
- MEM: Speicher
- PERx: Peripherieeinheiten

## Patentansprüche

1. Speichereinrichtung zum Speichern von Daten, wobei die Speichereinrichtung zum Testen derselben in eine bestimmte Tests der Speichereinrichtung ermöglichende Testbetriebsart versetzbar ist,
**dadurch gekennzeichnet,**
**daß** die Speichereinrichtung durch eine einen bestimmten Schreibzugriff oder eine bestimmte Folge von Schreibzugriffen auf die Speichereinrichtung umfassende Kommandosequenz in die Testbetriebsart versetzbar ist.

2. Speichereinrichtung nach Anspruch 1,
**dadurch gekennzeichnet,**
**daß** die Speichereinrichtung ausschließlich durch die Kommandosequenz in die in die Testbetriebsart versetzbar ist.

3. Speichereinrichtung nach Anspruch 1 oder 2,
**dadurch gekennzeichnet,**
**daß** die Speichereinrichtung durch die Kommandosequenz in einen Zustand versetzt wird, in welchem sie durch weitere Schreibzugriffe auf sie zur Ausführung von Operationen veranlaßbar ist, die sie außerhalb der Testbetriebsart nicht ausführt.

4. Speichereinrichtung nach Anspruch 3,
**dadurch gekennzeichnet,**
**daß** in der Speichereinrichtung durch die Kommandosequenz eine ein oder mehrere Bits umfassende Kennung gesetzt wird, und daß die Speichereinrichtung die ausschließlich in der Testbetriebsart ausführbaren Operationen nur ausführt, wenn und so lange diese Kennung gesetzt ist.

5. Speichereinrichtung nach einem der vorhergehenden Ansprüche,
**dadurch gekennzeichnet,**
**daß** die Speichereinrichtung durch einen Schreibzugriff oder eine bestimmte Folge von Schreibzugriffen auf sie dazu veranlaßbar ist, die Testbetriebsart zu verlassen.

6. Speichereinrichtung nach einem der vorhergehenden Ansprüche,
**dadurch gekennzeichnet,**
**daß** die Speichereinrichtung die Testbetriebsart beim Auftreten bestimmter Bedingungen automatisch verläßt.

7. Speichereinrichtung nach Anspruch 6,
**dadurch gekennzeichnet,**
**daß** die bestimmten Bedingungen den Umstand umfassen, daß auf die Speichereinrichtung ein Schreibzugriff erfolgt, auf den hin die Speichereinrichtung eine Operation auszuführen hat, die sie außerhalb der Testbetriebsart ausführen kann.

8. Speichereinrichtung nach Anspruch 6,
**dadurch gekennzeichnet,**
**daß** die bestimmten Bedingungen den Umstand umfassen, daß auf die Speichereinrichtung ein unzulässiger Schreibzugriff erfolgt.

9. Speichereinrichtung nach Anspruch 6,
**dadurch gekennzeichnet,**
**daß** die bestimmten Bedingungen den Umstand umfassen, daß seit dem Zeitpunkt, zu dem die Speichereinrichtung in die Testbetriebsart versetzt wurde, eine bestimmte Zeit vergangen ist.

10. Speichereinrichtung nach einem der vorhergehenden Ansprüche,
**dadurch gekennzeichnet,**
**daß** die Speichereinrichtung in einen Protected Mode versetzbar ist, in welchem die in der Speichereinrichtung gespeicherten Daten oder bestimmte Teile derselben nicht oder nur durch bestimmte Komponenten des die Speichereinrichtung enthaltenden Systems ausgelesen und/oder verändert werden können.

11. Speichereinrichtung nach Anspruch 10,
**dadurch gekennzeichnet,**
**daß** die Speichereinrichtung nicht in die Testbetriebsart versetzbar ist, wenn und so lange sie sich im Protected Mode befindet.

12. Speichereinrichtung nach Anspruch 10,
**dadurch gekennzeichnet,**
**daß** der Protected Mode unter Verwendung eines Passwortes temporär deaktivierbar ist, und daß die Kommandosequenz, durch welche die Speichereinrichtung in die Testbetriebsart versetzbar ist, ebenfalls ein Passwort enthält, wobei dann, wenn das Passwort zur Deaktivierung des Protected Mode und das Passwort zum Bringen der Speichereinrichtung in die Testbetriebsart bestimmte Gemeinsamkeiten oder gegenseitige Abhängigkeiten aufweisen, die Speichereinrichtung auch bei aktiviertem Protected Mode in die Testbetriebsart versetzbar ist.

13. Speichereinrichtung nach einem der vorhergehenden Ansprüche,
**dadurch gekennzeichnet,**
**daß** die Speichereinrichtung durch verschiedene Kommandosequenzen in verschiedene, unterschiedliche Testmöglichkeiten offerierende Testbetriebsarten versetzbar ist.

14. Speichereinrichtung nach einem der vorhergehenden Ansprüche,
**dadurch gekennzeichnet,**
**daß** die Speichereinrichtung durch Kommandosequenzen auch zur Durchführung anderer Operationen als zum Versetzen der Speichereinrichtung in die Testbetriebsart veranlaßbar ist.

15. Speichereinrichtung nach Anspruch 14,
**dadurch gekennzeichnet,**
**daß** die anderen Operationen im normalen Betrieb der Speichereinrichtung benötigte Operationen umfassen.

16. Speichereinrichtung nach Anspruch 14 oder 15,
**dadurch gekennzeichnet,**
**daß** die anderen Operationen das Verändern und/oder das Löschen von in der Speichereinrichtung gespeicherten Daten umfassen.

17. Speichereinrichtung nach einem der Ansprüche 14 bis 16,
**dadurch gekennzeichnet,**
**daß** die Speichereinrichtung nach jedem Schreibzugriff auf sie, der Teil einer Kommandosequenz ist, aber nicht Teil einer Kommandosequenz ist, durch welche die Ausführung einer im normalen Betrieb ausführbaren Operation veranlaßbar ist, eine Fehlermeldung ausgibt.

18. Speichereinrichtung nach Anspruch 17,
**dadurch gekennzeichnet,**
**daß** die Speichereinrichtung nach jedem Schreibzugriff auf sie, der Teil der Kommandosequenz ist, durch welche die Speichereinrichtung in die Testbetriebsart versetzt wird, eine Fehlermeldung ausgibt.

19. Speichereinrichtung nach einem der vorhergehenden Ansprüche,
**dadurch gekennzeichnet,**
**daß** die Speichereinrichtung ein Flash-Speicher ist.

20. Speichereinrichtung nach einem der vorhergehenden Ansprüche,
**dadurch gekennzeichnet,**
**daß** die Speichereinrichtung Bestandteil einer programmgesteuerten Einheit ist.

## Claims

1. Memory device for storing data, the memory device, for the testing thereof, being able to be put into a test operating mode enabling specific tests of the memory device,
**characterized**
**in that** the memory device can be put into the test operating mode by a command sequence comprising a specific write access or a specific sequence of write accesses to the memory device.

2. Memory device according to Claim 1,
**characterized**
**in that** the memory device can be put into the test operating mode exclusively by the command sequence.

3. Memory device according to Claim 1 or 2,
**characterized**
**in that** the command sequence puts the memory device into a state in which further write accesses to it can cause it to execute operations which it does not execute outside the test operating mode.

4. Memory device according to Claim 3,
**characterized**
**in that** an identifier comprising one or a plurality of bits is set in the memory device by the command sequence, and in that the memory device executes the operations that can be executed exclusively in the test operating mode only if and as long as this identifier is set.

5. Memory device according to one of the preceding claims,
**characterized**
**in that** a write access or a specific sequence of write accesses to the memory device can cause it to leave the test operating mode.

6. Memory device according to one of the preceding claims,
**characterized**
**in that** the memory device automatically leaves the test operating mode when specific conditions occur.

7. Memory device according to Claim 6,
**characterized**
**in that** the specific conditions comprise the circumstance that the memory device is subjected to a write access in response to which the memory device has to execute an operation which it can execute outside the test operating mode.

8. Memory device according to Claim 6,
**characterized**
**in that** the specific conditions comprise the circumstance that the memory device is subjected to an impermissible write access.

9. Memory device according to Claim 6,
**characterized**
**in that** the specific conditions comprise the circumstance that a specific time has elapsed since the point in time at which the memory device was put into the test operating mode.

10. Memory device according to one of the preceding claims,
**characterized**
**in that** the memory device can be put into a protected mode in which the data stored in the memory device or specific parts of the said data cannot be read out and/or altered or can be read out and/or altered only by specific components of the system containing the memory device.

11. Memory device according to Claim 10,
**characterized**
**in that** the memory device cannot be put into the test operating mode if and as long as it is in the protected mode.

12. Memory device according to Claim 10,
**characterized**
**in that** the protected mode can be temporarily deactivated using a password, and in that the command sequence by which the memory device can be put into the test operating mode likewise contains a password, in which case, when the password for deactivating the protected mode and the password for bringing the memory device into the test operating mode have specific commonalities or mutual dependencies, the memory device can be put into the test operating mode even in the case of an activated protected mode.

13. Memory device according to one of the preceding claims,
**characterized**
**in that** the memory device can be put into different test operating modes, offering various test possibilities, by different command sequences.

14. Memory device according to one of the preceding claims,
**characterized**
**in that** command sequences can also cause the memory device to carry out operations other than those for putting the memory device into the test operating mode.

15. Memory device according to Claim 14,
**characterized**
**in that** the other operations comprise operations required during normal operation of the memory device.

16. Memory device according to Claim 14 or 15,
**characterized**
**in that** the other operations comprise the alteration and/or the erasure of data stored in the memory device.

17. Memory device according to one of Claims 14 to 16,
**characterized**
**in that** the memory device outputs an error message after any write access to it which is part of a command sequence but is not part of a command sequence that can cause the execution of an operation that can be executed during normal operation.

18. Memory device according to Claim 17,
**characterized**
**in that** the memory device outputs an error message after any write access to it which is part of the command sequence that puts the memory device into the test operating mode.

19. Memory device according to one of the preceding claims,
**characterized**
**in that** the memory device is a flash memory.

20. Memory device according to one of the preceding claims,
**characterized**
**in that** the memory device is part of a program-controlled unit.

## Revendications

1. Dispositif de mémorisation pour mémoriser des données, le dispositif de mémorisation, pour tester celles-ci, pouvant être amené en un mode de test donné permettant de réaliser des tests du dispositif de mémorisation, **caractérisé en ce que** le dispositif de mémorisation peut être amené dans le mode de test par une séquence d'instructions comprenant un accès en écriture donné ou une séquence donnée d'accès en écriture au dispositif de mémorisation.

2. Dispositif de mémorisation selon la revendication 1, **caractérisé en ce que** le dispositif de mémorisation peut uniquement être amené en mode de test par la séquence d'instructions.

3. Dispositif de mémorisation selon la revendication 1 ou 2, **caractérisé en ce que** le dispositif de mémorisation est amené par la séquence d'instructions dans un état dans lequel d'autres accès en écriture peuvent lui ordonner d'exécuter des opérations qu'il n'exécute pas en-dehors du mode de test.

4. Dispositif de mémorisation selon la revendication 3, **caractérisé en ce qu'**un identifiant comprenant un ou plusieurs bits est activé dans le dispositif de mémorisation par la séquence d'instructions et que le dispositif de mémorisation n'exécute les opérations qui sont uniquement exécutables en mode de test que si et tant que cet identifiant est activé.

5. Dispositif de mémorisation selon l'une des revendications précédentes, **caractérisé en ce que** le dispositif de mémorisation peut, par un accès en écriture ou une séquence donnée d'accès en écriture, recevoir l'ordre de quitter le mode de test.

6. Dispositif de mémorisation selon l'une des revendications précédentes, **caractérisé en ce que** le dispositif de mémorisation quitte automatiquement le mode de test en présence de conditions données.

7. Dispositif de mémorisation selon la revendication 6, **caractérisé en ce que** les conditions données comprennent la situation dans laquelle un accès en écriture au dispositif de mémorisation a lieu sur lequel le dispositif de mémorisation doit exécuter une opération qu'il peut exécuter en-dehors du mode de test.

8. Dispositif de mémorisation selon la revendication 6, **caractérisé en ce que** les conditions données comprennent la situation dans laquelle a lieu un accès en écriture non autorisé au dispositif de mémorisation.

9. Dispositif de mémorisation selon la revendication 6, **caractérisé en ce que** les conditions données comprennent la situation dans laquelle un certain temps s'est écoulé depuis le moment où le dispositif de mémorisation a été amené en mode de test.

10. Dispositif de mémorisation selon l'une des revendications précédentes, **caractérisé en ce que** le dispositif de mémorisation peut être amené en un mode protégé dans lequel les données mémorisées dans le dispositif de mémorisation ou certaines parties de celles-ci ne peuvent pas être consultées et/ou modifiées ou alors seulement par certains composants du système qui contient le dispositif de mémorisation.

11. Dispositif de mémorisation selon la revendication 10, **caractérisé en ce que** le dispositif de mémorisation ne peut pas être amené en mode de test si et tant qu'il se trouve en mode protégé.

12. Dispositif de mémorisation selon la revendication 10, **caractérisé en ce que** le mode protégé peut être désactivé temporairement en utilisant un mot de passe et que la séquence d'instructions par le biais de laquelle le dispositif de mémorisation peut être amené en mode de test contient également un mot de passe, le dispositif de mémorisation pouvant alors également être amené en mode de test même lorsque le mode protégé est activé lorsque le mot de passe destiné à désactiver le mode protégé et le mot de passe destiné à amener le dispositif de mémorisation en mode de test présentent certains points communs ou des dépendances mutuelles.

13. Dispositif de mémorisation selon l'une des revendications précédentes, **caractérisé en ce que** le dispositif de mémorisation peut être amené par différentes séquences d'instructions dans des modes de test offrant diverses possibilités de test différentes.

14. Dispositif de mémorisation selon l'une des revendications précédentes, **caractérisé en ce que** le dispositif de mémorisation peut également être amené, par des séquences d'instructions, à exécuter d'autres opérations que de faire passer le dispositif de mémorisation en mode de test.

15. Dispositif de mémorisation selon la revendication 14, **caractérisé en ce que** les autres opérations comprennent les opérations nécessaires pendant le fonctionnement normal du dispositif de mémorisation.

16. Dispositif de mémorisation selon la revendication 14 ou 15, **caractérisé en ce que** les autres opérations comprennent la modification et/ou la suppression des données mémorisées dans le dispositif de mémorisation.

17. Dispositif de mémorisation selon l'une des revendications 14 à 16, **caractérisé en ce que** le dispositif de mémorisation émet un message d'erreur après chaque accès en écriture à lui qui est une partie d'une séquence d'instructions, mais qui n'est pas une partie d'une séquence d'instructions qui permet d'ordonner l'exécution d'une opération pouvant être exécutée en fonctionnement normal.

18. Dispositif de mémorisation selon la revendication 17, **caractérisé en ce que** le dispositif de mémorisation émet un message d'erreur après chaque accès en écriture à lui qui est une partie d'une séquence d'instructions avec laquelle le dispositif de mémorisation est amené en mode de test.

19. Dispositif de mémorisation selon l'une des revendications précédentes, **caractérisé en ce que** le dispositif de mémorisation est une mémoire flash.

20. Dispositif de mémorisation selon l'une des revendications précédentes, **caractérisé en ce que** le dispositif de mémorisation fait partie d'un module commandé par programme.
